# EUROPEAN PATENT SPECIFICATION

(11) **EP 2 639 330 B1**
(45) Date of publication and mention of the grant of the patent: **20.09.2017**
(21) Application number: 11839748.8
(22) Date of filing: 31.10.2011
(51) Int. Cl.: C23C 14/28, H05H 1/48, H01J 37/34, H05H 1/50

(54) **METHOD AND DEVICE FOR TRANSPORTING VACUUM ARC PLASMA**
VERFAHREN UND VORRICHTUNG ZUM TRANSPORT VON VAKUUMBOGENPLASMA
PROCÉDÉ DE TRANSPORT DE PLASMA À ARC SOUS VIDE ET DISPOSITIF DE MISE EN OEUVRE

(30) Priority: 08.11.2010 UA 2010013230
(43) Date of publication of application: 18.09.2013
(73) Proprietor: National Science Center Kharkov Institute Of Physics and Technology (NSC KIPT), Kharkov 61108 (UA)
(72) Inventor: VASYLIEV, Volodymyr Vasilievich, Kharkov 61089 (UA); STRELNYTSKIY, Volodymyr Evgenievich, Kharkov 61098 (UA)
(74) Representative: Sloboshanin, Sergej
(86) International application number: PCT/UA2011/000105
(87) International publication number: WO 2012/064311

(56) References cited:
- RU-C2- 2 369 664
- UA-C2- 87 880
- US-A- 4 452 686
- US-A- 5 840 163
- US-A1- 2002 007 796
- US-A1- 2002 007 796
- US-A1- 2003 193 031

## Description

### Field of Invention

The invention relates to a technique for forming flows of vacuum arc cathode erosion plasma to produce high-quality coatings for various applications: wear-resistant, friction proof, decorative, etc., and for surface modification of materials by irradiation with ion and/or electron fluxes.

### Prior Art

It is known that vacuum arc cathode plasma with macroparticle filtering is transported in the crossed electric and magnetic fields, when the electrons are magnetized and the ions are unmagnetized. In such conditions ions in plasma are focused optically, and the systems that ensure such focusing are referred to as the plasma-optical systems.

Vacuum arc cathode plasma is generated by vacuum arc cathode spots during electric arc evaporation in the form of high-speed plasma jets and macroparticle flows produced from the liquid phase of the vacuum arc cathode spots. Plasma jets can be controlled through magnetic and electric fields. Macroparticles move independently of magnetic or electric fields, virtually on linear paths, since they are characterized by a higher mass compared to plasma ions and a small charge per their mass unit. Therefore, macroparticles can be reflected only using appropriate means in the form of screens or captured by special traps. Presence of the means to reflect or capture macroparticles significantly reduces the plasma flow at the transport system outlet, since a significant share of the plasma is deposited on these means.

A known method [1] provides for transport of the vacuum arc cathode plasma with macroparticle filtering from the electric arc evaporator to the plasma source outlet in response to a non rectilinear constant transport magnetic field induced by electromagnetic coils.

A known plasma-optical system [1] provides for transport of the vacuum arc cathode plasma with macroparticle filtering from the electric arc evaporator to the plasma source outlet and comprises a plasma guide. The transport magnetic field is established using electromagnetic coils encircling the cathode, the anode, and the plasma guide. In this system, the plasma guide is curved in the quarter torus shape and electrically insulated from the anode.

The document UD 5,840,163 refers to a rectangular vacuum-arc plasma source and associated apparatus for generating and directing a stream of plasma containing an ionized vapor of a cathode material toward a substrate by vacuum arc evaporation of a rectangular planar cathode mounted in a rectangular plasma duct. The rectangular duct conducts the plasma from the cathode to the substrate region, while intercepting the molten droplets of cathode material also generated by the arc. Magnets control the arc motion on the cathode surface while simultaneously generating the magnetic field which guides the plasma through the duct. Benefits of a filtered cathodic arc (fully ionized vapour stream, elimination of splattered droplets) are combined with the benefits of a rectangular source (uniform evaporation from the source and uniform deposition on the substrate using linear motion). The rectangular source may be extended indefinitely in length, thus allowing coating or ion implantation on large or long substrates.

The document US 2003/0193031 relates to implementation of magnetic and electrostatic forces to guide ions along curved trajectories in an ion source such that macroparticles are separated from the ion stream. Magnetic and electrostatic fields act to cause ions to flow along curved trajectories from the arc source to an area where workpieces may be treated. Since macroparticles produced by consumable electrode sources are much less affected by magnetic and electrostatic fields, said macroparticles are able to be separated from the ion stream due to the curved trajectories followed by the ions. This filtering technique allows separation of macroparticles from the ion stream without substantially compromising deposition area, deposition rate, ion transport efficiency and/or uniformity in coating.

The document US 2002/0007796 discloses an apparatus for the application of coatings in a vacuum which comprises a plasma duct surrounded by a magnetic deflecting system communicating with a first plasma source and a coating chamber in which a substrate holder is arranged off of an optical axis of the plasma source, has at least one deflecting electrode mounted on one or more walls of the plasma duct. In one embodiment an isolated repelling or repelling electrode is positioned in the plasma duct downstream of the deflecting electrode where the tangential component of a deflecting magnetic field is strongest, connected to the positive pole of a current source which allows the isolated electrode current to be varied independently and increased above the level of the anode current. The deflecting electrode may serve as a getter pump to improve pumping efficiency and divert metal ions from the plasma flow. In a further embodiment a second arc source is activated to coat the substrates while a first arc source is activated, and the magnetic deflecting system for the first arc source is deactivated to confine plasma to the cathode chamber but permit electrons to flow into the coating chamber for plasma immersed treatment of the substrates. A load lock shutter may be provided between the plasma duct and the coating chamber further confine the plasma from the first arc source.

Reduction of plasma transport losses in such curved plasma-optical systems, however, requires powerful magnetic fields or large plasma-guide and anode cross-sections. This is a disadvantage of both the known method and the device for its implementation. Another disadvantage is significant inhomogeneity of the plasma flow intensity across its section at the plasma guide outlet. A time-averaged plasma flow at the outlet of a plasma source with such a plasma-optical system is irregularly distributed on the deposited surface due to significant plasma losses during its emission from the peripheral area of the consumable cathode's (buttend) working surface. Therefore, obtaining regular-thickness coatings on the surface with a spot diameter larger than the cathode diameter without rotating the base about its axis, which has to be displaced relative to the plasma flow axis, is quite challenging. It is known the prototype of a method [2] for the transport of vacuum arc cathode plasma with macroparticle filtering from the electric arc evaporator to the plasma source outlet in response to a non rectilinear constant transport magnetic field induced by electromagnetic coils. It is also known the prototype of a rectilinear plasma-optical system [2] with a plasma guide for the transport of vacuum arc cathode plasma with macroparticle filtering from the electric arc evaporator to the plasma source outlet. This plasma-optical system comprises an anode and a plasma guide with macroparticle reflectors, and electromagnetic coils for inducing a constant transport magnetic field. The coils encircle the cathode, the anode, and the plasma guide. Inside the anode there is a macroparticle reflector placed on its axis and shaped as an electroconductive tube segment with a dead buttend facing the cathode. Inside the tube segment there is a coaxially placed electromagnetic deflection coil designed to create a magnetic field directed opposite to the magnetic field induced by the electromagnetic coils encircling the cathode, the anode, and the plasma guide. The electric arc evaporator is fed from a dedicated power supply source.

When using this method and this device, plasma flows from the cathode spots of the arc in the vacuum electric arc discharge travel along the transporting magnetic field and travel around the tube segment inside the anode. This somewhat reduces plasma losses due to deposition on the section.

However, despite some reduction in such losses, this method, assumed as the prototype, and the plasma-optical system in which the method is implemented have disadvantages still resulting in significant losses of plasma flows during their transport. One such disadvantage is formation of a magnetic mirror between the inner anode surface and outer lateral surface of the said tube segment due to longitudinally increased magnetic field intensity. Thereby, plasma electrons with the kinetic energy transverse to the magnetic field higher than the longitudinal one are captured in a magnetic trap limited by the areas with the magnetic field maxima. One such maximum is found close to the evaporable cathode buttend, and the other one between the anode inner surface and outer lateral surface of the said tube segment. The electrons, while moving along the magnetic field and repeatedly reflected from the magnetic plugs formed in the areas with the magnetic field maxima, quickly escape the plasma flow to the anode inner surface. Such escape of electrons occurs both due to their diffusion transversely to the magnetic field following collisions and due to the electron drift towards the anode inner surface in response to the electric field cross-polarizing the plasma jet in the magnetic field. Such polarization is caused by the drift of magnetized electrons relative to unmagnetized ions across the magnetic field and outer electric field. Presence of the magnetic field's transverse gradient directed towards the outer surface of said tube segment also causes electrons to drift transversely to the magnetic field and its transverse gradient. In such conditions both these factors will add up to increase the intensity of the electric field cross-polarizing the plasma jet, where the electrons will be drifting towards the anode inner wall. According to the plasma quasi-neutrality condition, the same number of ions will escape plasma. This will reduce the ion current at the anode outlet.

A second disadvantage reducing the average output ion current from a plasma source is caused by the reasons shown below. For the fixed arc current, the difference of potentials between the plasma jet and the anode or between the plasma jet and the plasma guide keeps varying due to continuous variations in the positions of the arc cathode spots moving across the cathode working (buttend) surface. If the cathode spots move in the peripheral area of the cathode working (buttend) surface, the plasma jets coming out of these spots travel close to the inner surfaces of the anode and the plasma guide (or macroparticle-reflecting screens attached to the anode and the plasma guide). The closer the plasma jet approaches the anode and plasma guide inner surfaces, the more plasma flow finds its way onto these surfaces, thus reducing the ion current from a plasma source. This disadvantage is common for all the existing electric arc plasma sources, where cathode plasma with macroparticle filtering is transported in a similar manner in a similar system, both in the prototype and other counterparts.

### Disclosure of the Invention

The object of the invention is to improve both the method for the transport of vacuum arc cathode plasma with macroparticle filtering and the device for its implementation. These improvements are designed to reduce plasma losses during its transport. To achieve this it is necessary to provide for such plasma flow transport conditions that for various positions of the arc cathode spots on the cathode buttend surface would allow plasma flows to efficiently go around the structural elements on the plasma source surfaces that reflect and capture macroparticles.

The problem is solved in the proposed method of vacuum arc cathode plasma transport with macroparticle filtering from the electric arc evaporator to the plasma source outlet, where, like in the method adopted as the prototype, the plasma flows are transported in response to a transport magnetic field induced by electromagnetic coils.

Unlike the prototype, in the proposed invention the transport magnetic field is induced by superposition of a constant magnetic field and intensity variable additional magnetic fields deflecting the plasma flows from the surfaces of the plasma source structural elements. The additional magnetic fields are induced using additional electromagnetic coils. The intensity of the corresponding additional magnetic field is increased as the plasma flow approaches the surface of a corresponding structural element and reduced as the plasma flow moves away from the element surface.

When transporting plasma flows in the rectilinear plasma-optical system, the constant transport magnetic field is induced by two electromagnetic coils, one of which encircles the cathode, and the other one the plasma guide close to its outlet.

When transporting plasma fields in a non rectilinear plasma-optical system, the constant transport magnetic field is induced by coils, which correspondingly encircle the cathode, and the non rectilinear part of the plasma-optical system.

Both in the rectilinear and the non rectilinear plasma-optical systems, when transporting plasma flows inside the anode, the additional magnetic field is established using an additional electromagnetic coil encircling it. The coil's magnetic field has to be co-directed with the constant transport magnetic field on the plasma-optical system axis. In so doing, the intensity of the additional magnetic field is varied so that for a fixed difference of potential between the cathode and the anode its value is proportional to the arc current flowing through the anode, or for a fixed arc current flowing through the anode its value is inversely proportional to the anode potential drop.

In the rectilinear plasma-optical system that has the anode with an electrically connected macroparticle reflector located inside it on its axis and shaped as an electroconductive tube segment with a dead buttend facing the cathode, the plasma flow between the outer surface of this tube segment and the inner surface of the anode is transported when exposed to an additional magnetic field, induced by the electromagnetic deflection coil coaxially placed inside the tube segment, provided it is directed oppositely to the constant transport magnetic field on the plasma-optical system axis. The intensity of the additional magnetic field is increased or reduced in direct ratio to the increasing or decreasing arc current flowing through the tube segment.

Further transport of plasma flows coming out of the anode section is effecting in the plasma guide, inside of which the plasma flow is exposed to an additional magnetic field co-directed with the constant transport magnetic field. This additional magnetic field is generated using an additional electromagnetic coil encircling the plasma guide. Its intensity is increased or reduced in direct ratio to the increasing or reducing current, flowing through the plasma guide when the positive, relative to the anode, potential is supplied to it.

In another option the plasma flow coming from the anode is transported in a plasma guide comprising the inlet and the outlet parts electrically insulated from each other and from the anode. In doing so, the plasma flow is affected by an additional magnetic field co-directed with the constant transport magnetic field. In this case it is generated by an additional electromagnetic coil, encircling the plasma guide inlet part. Its intensity is increased or reduced in direct ratio to the increasing or reducing current, flowing through the plasma guide outlet part when the positive, relative to the anode, potential is supplied to it.

The problem is solved in the rectilinear plasma-optical system proposed for transporting the vacuum arc cathode plasma with macroparticle filtering from the electric arc evaporator to the plasma source outlet. This system, like the system assumed as the prototype, comprises macroparticle reflectors; electromagnetic coils encircling the cathode, the anode, and the plasma guide; and an electroconductive tube segment coaxially placed inside the anode, electrically connected thereto, and having its dead buttend facing the cathode and an electromagnetic deflection coil coaxially placed inside.

Unlike the prototype, in the proposed system the electric arc evaporator power supply source is connected to the anode through the winding of the electromagnetic coil that encircles it. The initial turn of the electromagnetic deflection coil winding inside the tube segment is electrically connected to it, the lead of the last turn of the coil being connected to the positive terminal of the arc power supply source.

In this plasma-optical system the electromagnetic deflection coil inside the tube segment can be constructed of a water-cooled pipe.

In such a plasma-optical system, the plasma guide can be encircled with an additional electromagnetic coil, whose one end is electrically connected to the plasma guide and the other end - to the positive terminal of a separate power supply source, whose negative terminal is connected to the anode.

In another embodiment of a plasma-optical system, the plasma guide can be constructed of two parts (inlet and outlet) electrically insulated from each other and from the anode. The plasma guide inlet can be encircled by an additional electromagnetic coil, whose one end is electrically connected to the plasma guide outlet and the other end - to the positive terminal of a separate power supply source, whose negative terminal is connected to the anode.

Let us consider how the deflective action of additional magnetic fields on plasma flows during their approach to the surfaces of the plasma source structural elements with macroparticle reflectors, carried out in the above described conditions, reduces plasma flow transport losses.

To achieve this in a linear plasma-optical system, the constant component of the transport magnetic field must have a configuration convex from the axis, which is implemented, as shown above, with two electromagnetic coils encircling the cathode and the plasma guide outlet part respectively. The transverse gradient of this magnetic field's component is directed towards the axis of the plasma-optical system. Inside the plasma jet, the gradient induces separation of the electrical charges that create the electric polarization field directed transversely to the magnetic field and its gradient. This electric field causes electrons to drift transversely to the magnetic field and the electric polarization field, i.e. towards the inner surface of the anode, thus somewhat reducing plasma deposition on the tube segment with a dead buttend placed inside the anode. To intensify this effect, the above mentioned transverse gradient has to be sufficient for the plasma electron gradient drift velocity to be at least as high as the velocity of the oppositely directed electron drift in the external electric field between the plasma jet and the tube segment placed inside the anode under its potential. This is ensured by the effect of an additional magnetic field established with an electromagnetic coil coaxially placed inside the tube segment located inside the anode. The field intensity increases or decreases in direct ratio to the increasing or decreasing arc current, flowing through the tube segment, since it is electrically connected to an end of the electromagnetic deflection coil winding, whose other end is connected to the positive terminal of the vacuum arc power supply source. As a consequence, plasma flows coming out of the cathode spots close to the cathode axis are more efficiently deflected from the outer surface of the said tube segment towards the anode inner surface, thus leading to significantly lower losses of ions from the plasma jet on this macroparticle-reflecting structural element.

However, when the cathode spots during electric arc evaporation travel on the periphery of the cathode buttend surface, the plasma flows emitted by these cathode spots closely approach to the surfaces of the macroparticle reflectors on the anode and the plasma guide. To reduce diffusion plasma flow losses on these surfaces, the plasma flows are exposed to corresponding additional magnetic fields co-directed with the constant transport magnetic field. These fields are established by electromagnetic coils encircling the anode and the plasma guide respectively and duly connected to power supply sources as described above. Therefore, the intensities of these fields are increased when the plasma flows have to be deflected from the corresponding surfaces and decreased when the plasma flows withdraw from them. This ensures reduced plasma flow losses in transport.

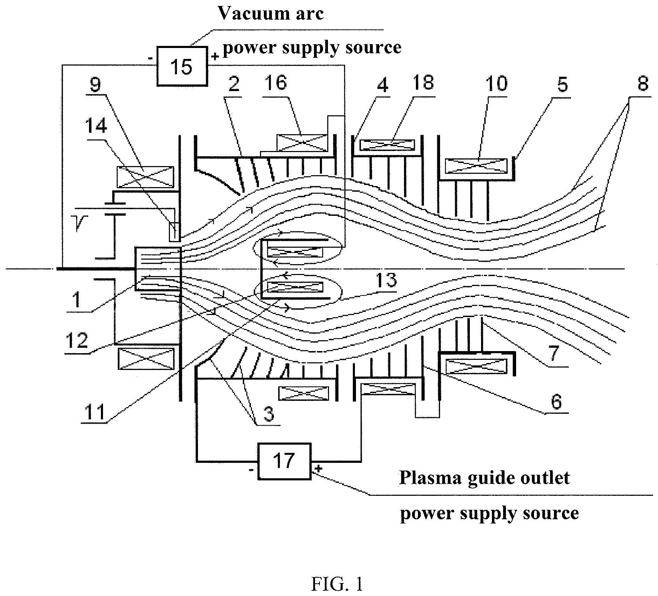

The nature of invention is explained by the drawing of the implementation device for the proposed method.

### Best Implementation Examples for Proposed Invention

Example 1. As an implementation example of the patented invention, let us first consider the proposed device. This is a linear embodiment of a plasma-optical system for transport of vacuum arc cathode plasma with macroparticle filtering. This system (see drawing) comprises a cathode 1 and an anode 2, with macroparticle reflectors placed therein shaped as annular screens 3. The plasma guide in the system is constructed of two parts - inlet 4 and outlet 5, which are electrically insulated from each other and from the anode 2. Inside, these plasma guide parts contain macroparticle reflectors shaped as sets of annular screens 6 and 7. The constant component of the transport magnetic field 8 is formed by electromagnetic coils 9 and 10, which encircle the cathode 1 and the outlet part of the plasma guide 5 respectively. Inside, the anode 2 contains a macroparticle reflector placed in coaxial relationship therewith and shaped as a tube segment 11 with a dead buttend facing the cathode 1. Inside, the tube segment contains an electromagnetic coil 12 with winds of pipe for water cooling. This electromagnetic coil is designed to generate an additional deflective magnetic field 13 directed on the system axis oppositely to the constant part of the transport magnetic field 8. Unit 14 is designed to ignite the vacuum arc. The vacuum arc power supply source 15 is connected to the anode 2 through the winding of the electromagnetic coil 16 that encircles it. The tube segment 11 is electrically connected to an end of the electromagnetic deflection coil 12, whose other end is connected to the positive terminal of the vacuum arc power supply source 15. The plasma guide is connected to a separate power supply source 17, whose negative terminal is connected to the anode 2, and the positive terminal, through the winding of the coil 18 that encircles the plasma guide inlet section 4, is connected to its outlet section 5.

Let us consider the method implementation example by describing the device operation.

The arc is ignited by feeding a high-voltage pulse to the arc ignition unit 14 (see drawing), thus initiating the excitation of the arc cathode spot on the cathode 1 lateral surface, which is driven by the magnetic field onto the cathode buttend (working) surface. Depending on the arc current, the cathode 1 buttend surface may generate several cathode spots, which, traveling across it, emit jets of high-ionization cathode plasma along with macroparticles of the cathode material. The macroparticles, traveling on linear paths, are delayed by the reflectors 3, 6, 7 and the buttend surface of the tube segment 11. The plasma jets, whose ionization approaches 100%, traveling along a convexly configured transport magnetic field 8, which goes around the tube segment 11, pass through all the apertures of the reflectors 3, 6, 7 towards the plasma source outlet. Depending on the position of the arc cathode spot on the cathode buttend surface, electromagnetic coils 16 and 18, encircling the anode 2 and the inlet section of the plasma guide 4 respectively, induce intensity variable electromagnetic fields. These fields change the configuration and the intensity of the resulting transport magnetic field, whose constant component is created using electromagnetic coils 9 and 10. The plasma flow is also affected by the additional deflecting magnetic field 13 inside the anode 2. This deflecting magnetic field is directed opposite to the constant transport magnetic field on the system axis and is induced using the electromagnetic deflection coil 12 coaxially placed inside the tubular section of the filtering element 11.

If the power supply source 15 operates in the fixed arc current mode, the intensities of the additional magnetic fields inside the anode 2 will be proportional to the arc currents flowing through the anode 2 and the tube segment of the macroparticle reflector 11. The intensities of these fields will also be inversely proportional to the anode potential drop. If the source 15 operates in the fixed voltage mode, then for the plasma flows approaching the inner surface of the anode 2 or the outer surface of the tube segment 11, the anode current to these electrodes will increase. This will increase the current flowing through the respective coil 16 or 12 and the intensity of the respective magnetic field that will deflect the plasma flow from the wall of the respective plasma source structural element.

Due to connection of the power supply source positive terminal 17 to the plasma guide outlet part 5 through an additional electromagnetic coil 18, the intensity of the additional magnetic field inside the plasma guide inlet part 4 for the specified constant potential with respect to the anode fed to the electromagnetic coil 18 will be proportional to the intensity of the current flowing through the plasma guide outlet part 5.

Under said conditions and for any travels of cathode spots on the cathode buttend surface, we achieve dynamic equilibrium of plasma flows in the transport area along the magnetic field, where plasma losses transversely to the magnetic field will be minimal. In this case, stability of such dynamic equilibrium of plasma flows and stabilization of voltage drop on the arc grows proportional to the arc current.

Example 2. The embodiment of the proposed method and device for the nonlinear plasma-optical system differs from the embodiment of the linear plasma-optical system in that the constant component of the transport magnetic field is created by electromagnetic coils encircling the cathode, the anode, and the plasma guide.

Inside the anode of a nonlinear system there is no tube segment with an electromagnetic deflection coil placed therein. The nonlinear plasma-optical system's operation in the arc direct current mode differs in the method of excitation of the anode-encircling additional electromagnetic coil. The difference, more particularly, is that the coil is excited from a separately controlled power supply source, which comprises a direct-current amplifier with a negative feedback on the anode voltage drop **Uₐ** on the arc corresponding to the ratio: **Uₐ = U_{arc} - U_{c},** where **U_{c}** and **U_{arc,}** are cathode arc voltage drop and total arc voltage drop.

In this particular case **Uₐ** is determined through a comparator, which sets a constant magnitude of **U_{c}** selected for the specified cathode material. In absence of the arc discharge **U_{arc} = U_{ocv},** where **U_{ocv}** is open circuit voltage of the arc power supply source.

Under such conditions the power supply source of the additional electromagnetic coil is cut off and the current in the coil equals zero. During arc ignition **Uₐ** decreases and the coil power supply source is triggered on. In consequence, the coil will be passing the current inversely proportional to the anode potential drop **Uₐ,** thus generating a corresponding additional magnetic field. When plasma jets approach the anode inner surface, **Uₐ** decreases and the intensity of the additional magnetic field inside the anode correspondingly increases. When plasma jets withdraw from the anode inner surface towards its axis, **Uₐ** increases and the intensity of the field inside the anode correspondingly decreases. This influence of the additional magnetic field on plasma flows does not deteriorate stability of the arc discharge, and plasma transport losses inside the anode are on the average reduced. During further transport of plasma flows in the plasma guide, the positive terminal with respect to the anode is fed to the nonlinear plasma guide through an additional electromagnetic coil encircling the plasma guide.

### Industrial Applicability

The experiments carried out using the device manufactured from real and available structural elements demonstrated that the proposed method and device for the transport of vacuum arc cathode plasma in a linear filtering plasma-optical system provides at least a 1.5-fold increase in the average outlet ion flux over the prototype at an arc current of 100 A. Further, the minimum and the maximum values of the outlet ion flux were 3.5 A and 4 A respectively. For the case when the arc current is brought up to 110 A, the minimum and the maximum outlet ion flux values increase to 4 A and 5 A respectively.

Thus, the data provided evidence that the proposed invention can be implemented to deposit high-quality coatings for various applications. Provision of the above described plasma flow transport conditions significantly improves productivity of the coating deposition process, devoid of the defects caused by macroparticles.

### References Cited

1. I.I. Aksyonov, V.A. Belous, V.G. Padalka, V.M. Khoroshikh. Device for Vacuum Arc Plasma Cleaning from Macroparticles // Instruments and Experimental Techniques, No. 5, 1978, p. 236-237.
2. Ukrainian Patent 87880. International Patent Classification C23C14/00. Vacuum Arc Plasma Source, 2009 (prototype).

## Claims

1. A plasma-optical system including a plasma guide for transporting the vacuum arc cathode plasma with macroparticle filtering from an electric arc evaporator to a plasma source outlet, comprising a cathode (1), an anode (2) and a vacuum arc power supply source (15), macroparticle reflectors (3), a first electromagnetic coil (9) encircling the cathode (1), a second electromagnetic coil (16) encircling the anode (2), If a third and fourth electromagnetic coils (18,10) encircling the plasma guide, and an electroconductive tube segment (11) coaxially placed inside the anode (2), electrically connected thereto and having its dead buttend facing the cathode (1) and including an electromagnetic deflection coil (12) coaxially placed therein ***characterized in that*** the vacuum arc power supply source (15) is connected to the anode (2) through the winding of the second electromagnetic coil (16) that encircles it, with the initial turn of the electromagnetic deflection coil winding (12) inside said tube segment (11) being electrically connected to said tube segment (11), and the lead of the last turn of the electromagnetic deflection coil (12) winding being connected to the positive terminal of the electric arc evaporator power supply source (15).

2. A plasma-optical system according to claim 1 ***characterized in that*** the electromagnetic deflection coil (12) inside said tube segment (11) is constructed of a water-cooled pipe.

3. A plasma-optical system according to claim 1 or claim 2 ***characterized in that*** it further comprises a separate power supply source (17), wherein the third electromagnetic coil (18) has one end electrically connected to the plasma guide and the other end to the positive terminal of the separate power supply source (17) whose negative terminal is connected to the anode (2).

4. A plasma-optical system according to claim or claim 2 ***characterized in that*** it further comprises a separate power supply (17), wherein the plasma guide is constructed of two parts, inlet (4) and outlet (5), electrically insulated from each other and from the anode (2), and the plasma guide inlet (4) is encircled with the third electromagnetic coil (18), whose one end is electrically connected to the plasma guide outlet (5) and the other end to the positive terminal of the separate power supply source (17) whose negative terminal is connected to the anode (2).

5. A method for transporting vacuum arc cathode plasma with macroparticle filtering in a plasma-optical system according to claim 1, from an electric arc evaporator to a plasma source outlet (5) in response to a transport magnetic field created by electromagnetic coils, wherein the plasma-optical system comprises a cathode (1), an anode(2) an electric arc evaporator power supply source (15), ***characterized in that*** the transport magnetic field is induced by superposition
of a constant magnetic field (8) and,
during transport of plasma flows, of intensity variable additional magnetic fields deflecting the plasma flows from the surfaces of plasma source structural elements,
wherein these additional magnetic fields being induced using the deflection, second and third electromagnetic coils (1, 16, 18), provided the intensity of the corresponding additional magnetic field is increased as the plasma flow approaches the surface of a corresponding plasma source structural element and is reduced as the plasma flow moves away from the element surface.

6. A method according to claim 5 ***characterized in that*** the plasma-optical system is rectilinear and, during transport of plasma flows the constant magnetic field (8) is induced by the first and the fourth electromagnetic coils (9, 10), the first (9) encircles the cathode (1), and the fourth (10) encircles the plasma guide close to its outlet (5).

7. A method according to claim 5 ***characterized in that*** the plasma-optical system is non rectilinear and, during transport of plasma flows, the constant magnetic field (8) is induced by the first electromagnetic coil (9) encircling the cathode (1), and the fourth electromagnetic coil (10) encircling the plasma guide which is the non rectilinear part of the plasma-optical system.

8. A method according to claim 6 or claim 7 ***characterized in that*** during transport of plasma flows inside the anode (2), the additional magnetic field is established using the additional electromagnetic coil (16) encircling it, provided this magnetic field is co-directed with the constant magnetic field (8), while the intensity of the additional magnetic field is varied so that, for a fixed difference of potential between the cathode (1) and the anode (2), its value is proportional to the arc current flowing through the anode (2), or for a fixed arc current flowing through the anode (2) its value is inversely proportional to the anode potential drop.

9. A method according to claims 8 and 6 ***characterized in that*** in the plasma source, where inside the anode (2) there is the electroconductive tube segment (11), electrically connected to it and located on its axis, with a dead buttend facing the cathode (1) for macroparticle reflection, the plasma flow between the outer surface of this tube segment (11) and the inner surface of the anode (2) is transported by exposing the plasma flow to an additional magnetic field (13), induced by the electromagnetic deflection coil (12) coaxially placed inside the tube segment (11), provided this magnetic field (13) is directed oppositely to the constant magnetic field (8) on the plasma-optical system axis, while the field intensity of the magnetic field (13) induced by this coil (12) is increased or decreased in direct ratio to the increasing or decreasing arc current flowing through the tube segment (11).

10. A method according to claim 8 ***characterized in that*** the plasma flow from the anode (2) is transported in the plasma guide, inside which the plasma flow is exposed to an additional magnetic field, co-directed with the constant magnetic field (8) and generated with the third electromagnetic coil (18) encircling the plasma guide, and the intensity of the additional magnetic field is increased or decreased in direct ratio to the increasing or decreasing current flowing through the plasma guide.

11. A method according to claim 9 ***characterized in that*** the plasma flow from the anode (2) is transported in the plasma guide, inside which the plasma flow is exposed to an additional magnetic field, co-directed with the constant magnetic field (8) and generated with the fourth electromagnetic coil (10) encircling the plasma guide, and the intensity of the additional magnetic field is increased or decreased in direct ratio to the increasing or decreasing current flowing through the plasma guide.

12. A method according to claim 8 ***characterized in that*** the plasma flow from the anode (2) is transported in the plasma guide, comprising the inlet (4) and the outlet (5) parts electrically insulated from each other and from the anode (2), while the plasma flow is exposed to an additional magnetic field, co-directed with the constant magnetic field (8) and generated with the third electromagnetic coil (18) encircling the plasma guide inlet (4), provided the intensity of the additional magnetic field is increased or reduced in direct ratio to the increasing or decreasing current flowing through the plasma guide outlet (5).

13. A method according to claim 9 ***characterized in that*** the plasma flow from the anode (2) is transported in the plasma guide, comprising the inlet (4) and the outlet (5) parts electrically insulated from each other and from the anode (2), while the plasma flow is exposed to an additional magnetic field, co-directed with the constant transport magnetic field (8) and generated with the third electromagnetic coil (18) encircling the plasma guide inlet (4), provided the intensity of the additional magnetic field is increased or reduced in direct ratio to the increasing or decreasing current flowing through the plasma guide outlet (5).

## Patentansprüche

1. Plasmaoptisches System umfassend eine Plasmaführung zum Transport des Vakuumbogen-Kathodenplasmas mit Makropartikelfilterung von einem elektrischen Bogenverdampfer zu einem Plasmaquellenauslass, umfassend eine Kathode (1), eine Anode (2) und eine Vakuumbogen-Stromquelle (15), Makropartikel-Reflektoren (3), eine erste elektromagnetische Spule (9), die die Kathode (1) umgibt, eine zweite elektromagnetische Spule (16), die die Anode (2) umgibt, eine dritte und eine vierte elektromagnetische Spule (18, 10), die die Plasmaführung umgeben, und einen elektrisch leitfähigen Röhrenabschnitt (11), der koaxial in der Anode (2) angeordnet und mit dieser elektrisch verbunden ist und dessen stumpfes totes Ende der Kathode (1) zugewandt ist, und umfassend eine darin koaxial angeordnete elektromagnetische Ablenkspule (12),
**dadurch gekennzeichnet, dass** die Vakuumbogen-Stromquelle (15) über die Wicklung der zweiten elektromagnetischen Spule (16), die sie umgibt, mit der Anode (2) verbunden ist, wobei die erste Windung der Wicklung der elektromagnetischen Ablenkspule (12) im Inneren des Röhrenabschnitts (11) elektrisch mit dem Röhrenabschnitt (11) und der Führung der letzten Windung der Wicklung der elektromagnetischen Ablenkspule (12) mit dem Pluspol einer Stromquelle (15) eines elektrischen Vakuumbogenverdampfers verbunden ist.

2. Plasmaoptisches System nach Anspruch 1, **dadurch gekennzeichnet, dass** die elektromagnetische Ablenkspule (12) im Inneren des Röhrenabschnitts (11) aus einem wassergekühlten Rohr hergestellt ist.

3. Plasmaoptisches System nach Anspruch 1 oder Anspruch 2, **dadurch gekennzeichnet, dass** es weiterhin eine separate Stromquelle (17) umfasst, wobei ein Ende der dritten elektromagnetischen Spule (18) elektrisch mit der Plasmaführung und das andere Ende mit dem Pluspol der separaten Stromquelle (17) verbunden ist, deren Minuspol mit der Anode (2) verbunden ist.

4. Plasmaoptisches System nach Anspruch 1 oder Anspruch 2, **dadurch gekennzeichnet, dass** es weiterhin eine separate Stromquelle (17) umfasst, wobei die Plasmaführung aus zwei Teilen aufgebaut ist, einem Einlass (4) und einem Auslass (5), die elektrisch voneinander und von der Anode isoliert sind, und der Plasmaführungseinlass (4) von der dritten elektromagnetischen Spule (18) umgeben ist, deren eines Ende elektrisch mit dem Plasmaführungsauslass (5) und das andere Ende mit dem Pluspol der separaten Stromquelle (17) verbunden ist, deren Minuspol mit der Anode (2) verbunden ist.

5. Verfahren zum Transportieren von Vakuumbogen-Kathodenplasma mit Makropartikelfilterung in einem plasmaoptischen System nach Anspruch 1 von einem elektrischen Bogenverdampfer zu einem Plasmaquellenauslass (5) als Reaktion auf ein von elektromagnetischen Spulen erzeugtes transportmagnetisches Feld, wobei das plasmaoptische System eine Kathode (1), eine Anode (2) und eine Stromquelle (15) eines elektrischen Vakuumbogenverdampfers umfasst, **dadurch gekennzeichnet, dass** das transportmagnetische Feld durch Superposition eines konstanten Magnetfelds (8) und, während des Transports von Plasmaflüssen, zusätzlicher Magnetfelder von variabler Intensität, die die Plasmaflüsse von den Oberflächen der Strukturelemente der Plasmaquellen ablenken, induziert wird, wobei diese zusätzlichen Magnetfelder induziert werden, indem die elektromagnetische Ablenkspule sowie zweite und dritte elektromagnetische Spulen (1, 16, 18) verwendet werden, vorausgesetzt, dass die Intensität des entsprechenden zusätzlichen Magnetfelds erhöht wird, wenn der Plasmafluss sich der Oberfläche eines entsprechenden Strukturelements der Plasmaquelle nähert, und reduziert wird, wenn sich der Plasmafluss von der Elementoberfläche weg bewegt.

6. Verfahren nach Anspruch 5, **dadurch gekennzeichnet, dass** das plasmaoptische System geradlinig ist und während des Transports der Plasmaflüsse das konstante Magnetfeld (8) durch die erste und die vierte elektromagnetische Spule (9, 10) induziert wird, wobei die erste (9) die Kathode (1) umgibt und die vierte (10) die Plasmaführung in der Nähe ihres Auslasses (5) umgibt.

7. Verfahren nach Anspruch 5, **dadurch gekennzeichnet, dass** das plasmaoptische System nicht geradlinig ist und während des Transports der Plasmaflüsse das konstante Magnetfeld (8) durch die erste elektromagnetische Spule (9), die die Kathode (1) umgibt, und die vierte elektromagnetische Spule (10) induziert wird, die die Plasmaführung umgibt, die den nicht-geradlinigen Teil des plasmaoptischen Systems bildet.

8. Verfahren nach Anspruch 6 oder Anspruch 7, **dadurch gekennzeichnet, dass** während des Transports der Plasmaflüsse im Inneren der Anode (2) das zusätzliche Magnetfeld aufgebaut wird, wobei die zusätzliche elektromagnetische Spule (16) verwendet wird, die sie umgibt, vorausgesetzt, dass dieses Magnetfeld mit dem konstanten Magnetfeld (8) gleichgerichtet ist, während die Intensität des zusätzlichen Magnetfelds variiert wird, so dass für eine festgelegte Potentialdifferenz zwischen der Kathode (1) und der Anode (2) sein Wert proportional zu dem Bogenstrom ist, der durch die Anode (2) fließt, oder für einen festgelegten Bogenstrom, der durch die Anode (2) fließt, sein Wert umgekehrt proportional zu dem Anodenpotentialabfall ist.

9. Verfahren nach den Ansprüchen 8 und 6, **dadurch gekennzeichnet, dass** bei der Plasmaquelle, wo der elektrisch leitfähige Röhrenabschitt (11) im Inneren der Anode (2) ist, der elektrisch mit ihr verbunden und an ihrer Achse angeordnet ist, wobei dessen stumpfes totes Ende für eine Makropartikelreflektion der Kathode (1) zugewandt ist, der Plasmafluss zwischen der äußeren Oberfläche dieses Röhrenabschnitts (11) und der inneren Oberfläche der Anode (2) transportiert wird, indem der Plasmafluss einem zusätzlichen Magnetfeld (13) ausgesetzt wird, das von der elektromagnetischen Ablenkspule (12) induziert wird, die koaxial im Inneren des Röhrenabschnitts (11) angeordnet ist, vorausgesetzt, dass dieses Magnetfeld (13) auf der Achse des plasmaoptischen Systems entgegengesetzt zu dem konstanten Magnetfeld (8) gerichtet ist, während die Feldintensität des Magnetfelds (13), das von dieser Spule (12) induziert wird, in direktem Verhältnis zu dem stärker oder schwächer werdenden Bogenstrom, der durch den Röhrenabschnitt (11) fließt, vergrößert oder verringert wird.

10. Verfahren nach Anspruch 8, **dadurch gekennzeichnet, dass** der Plasmafluss von der Anode (2) in der Plasmaführung transportiert wird, in deren Inneren der Plasmafluss einem zusätzlichen Magnetfeld ausgesetzt ist, das mit dem konstanten Magnetfeld (8) gleichgerichtet ist und mit der dritten elektromagnetischen Spule (18) erzeugt wird, die die Plasmaführung umgibt, und die Intensität des zusätzlichen Magnetfelds in direktem Verhältnis zu dem stärker oder schwächer werdenden Strom, der durch die Plasmaführung fließt, vergrößert oder verringert wird.

11. Verfahren nach Anspruch 9, **dadurch gekennzeichnet, dass** der Plasmafluss von der Anode (2) in der Plasmaführung transportiert wird, in deren Inneren der Plasmafluss einem zusätzlichen Magnetfeld ausgesetzt ist, das mit dem konstanten Magnetfeld (8) gleichgerichtet ist und mit der vierten elektromagnetischen Spule (10) erzeugt wird, die die Plasmaführung umgibt, und die Intensität des zusätzlichen Magnetfelds in direktem Verhältnis zu dem stärker oder schwächer werdenden Strom, der durch die Plasmaführung fließt, vergrößert oder verringert wird.

12. Verfahren nach Anspruch 8, **dadurch gekennzeichnet, dass** der Plasmafluss von der Anode (2) in der Plasmaführung transportiert wird, die den Einlassteil (4) und den Auslassteil (5) umfasst, die elektrisch voneinander und von der Anode (2) isoliert sind, während der Plasmafluss einem zusätzlichen Magnetfeld ausgesetzt ist, das mit dem konstanten Magnetfeld (8) gleichgerichtet ist und mit der dritten elektromagnetischen Spule (18) erzeugt wird, die den Plasmaführungseinlass (4) umgibt, vorausgesetzt, dass die Intensität des zusätzlichen Magnetfelds in direktem Verhältnis zu dem stärker oder schwächer werdenden Strom, der durch den Plasmaführungsauslass (5) fließt, vergrößert oder verringert wird.

13. Verfahren nach Anspruch 9, **dadurch gekennzeichnet, dass** der Plasmafluss von der Anode (2) in der Plasmaführung transportiert wird, die den Einlassteil (4) und den Auslassteil (5) umfasst, die elektrisch voneinander und von der Anode (2) isoliert sind, während der Plasmafluss einem zusätzlichen Magnetfeld ausgesetzt ist, das mit dem konstanten Magnetfeld (8) gleichgerichtet ist und mit der dritten elektromagnetischen Spule (18) erzeugt wird, die den Plasmaführungseinlass (4) umgibt, vorausgesetzt, dass die Intensität des zusätzlichen Magnetfelds in direktem Verhältnis zu dem stärker oder schwächer werdenden Strom, der durch den Plasmaführungsauslass (5) fließt, vergrößert oder verringert wird.

## Revendications

1. Système optique à plasma incluant un guide à plasma pour transporter le plasma cathodique à arc sous vide avec une filtration de macroparticules à partir d'un évaporateur à arc électrique jusqu'à une sortie de source de plasma, comprenant une cathode (1), une anode (2) et une source d'alimentation électrique à arc sous vide (15), des réflecteurs de macroparticules (3), une première bobine électromagnétique (9) encerclant la cathode (1), une deuxième bobine électromagnétique (16) encerclant l'anode (2), des troisième et quatrième bobines électromagnétiques (18, 10) encerclant le guide à plasma, et un segment de tube électroconducteur (11) placé coaxialement à l'intérieur de l'anode (2), connecté électriquement à celle-ci et ayant son bout fermé faisant face à la cathode (1) et incluant une bobine à déviation électromagnétique (12) placée coaxialement en son sein, **caractérisé en ce que** la source d'alimentation électrique à arc sous vide (15) est connectée à l'anode (2) par l'intermédiaire de l'enroulement de la deuxième bobine électromagnétique (16) qui l'encercle, la spire initiale de l'enroulement de bobine à déviation électromagnétique (12) à l'intérieur dudit segment de tube (11) étant connectée électriquement audit segment de tube (11), et le pas hélicoïdal de la dernière spire de l'enroulement de bobine à déviation électromagnétique (12) étant connecté électriquement à la borne positive de la source d'alimentation électrique à évaporateur à arc électrique (15).

2. Système optique à plasma selon la revendication 1, **caractérisé en ce que** la bobine à déviation électromagnétique (12) à l'intérieur dudit segment de tube (11) est constituée d'un tuyau refroidi par eau.

3. Système optique à plasma selon la revendication 1 ou la revendication 2, **caractérisé en ce qu'**il comprend en outre une source d'alimentation électrique séparée (17), dans lequel la troisième bobine électromagnétique (18) a une extrémité connectée électriquement au guide à plasma et l'autre extrémité à la borne positive de la source d'alimentation électrique séparée (17) dont la borne négative est connectée à l'anode (2).

4. Système optique à plasma selon la revendication 1 ou la revendication 2, **caractérisé en ce qu'**il comprend en outre une alimentation électrique séparée (17), dans lequel le guide à plasma est constitué de deux parties, l'entrée (4) et la sortie (5), isolées électriquement l'une de l'autre et de l'anode (2), et l'entrée de guide à plasma (4) est encerclée par la troisième bobine électromagnétique (18), dont une extrémité est connectée électriquement à la sortie de guide à plasma (5) et l'autre extrémité à la borne positive de la source d'alimentation électrique séparée (17) dont la borne négative est connectée à l'anode (2).

5. Méthode pour transporter un plasma cathodique à arc sous vide avec une filtration de macroparticules dans un système optique à plasma selon la revendication 1, à partir d'un évaporateur à arc électrique jusqu'à une sortie de source de plasma (5) en réponse à un champ magnétique de transport créé par des bobines électromagnétiques, dans laquelle le système optique à plasma comprend une cathode (1), une anode (2), une source d'alimentation électrique à évaporateur à arc électrique (15), **caractérisée en ce que** le champ magnétique de transport est induit par superposition d'un champ magnétique constant (8) et, durant le transport de flux de plasma, de champs magnétiques supplémentaires d'intensité variable déviant les flux de plasma des surfaces d'éléments structuraux de source de plasma, dans laquelle ces champs magnétiques supplémentaires sont induits à l'aide des deuxième et troisième bobines électromagnétiques à déviation (1, 16, 18), à condition que l'intensité du champ magnétique supplémentaire correspondant soit augmentée à mesure que le flux de plasma s'approche de la surface d'un élément structural de source de plasma correspondant et soit réduite à mesure que le flux de plasma s'éloigne de la surface de l'élément.

6. Méthode selon la revendication 5, **caractérisée en ce que** le système optique à plasma est rectiligne et, durant le transport de flux de plasma, le champ magnétique constant (8) est induit par les première et quatrième bobines électromagnétiques (9, 10), la première (9) encercle la cathode (1), et la quatrième (10) encercle le guide à plasma à proximité de sa sortie (5).

7. Méthode selon la revendication 5, **caractérisée en ce que** le système optique à plasma est non rectiligne et, durant le transport de flux de plasma, le champ magnétique constant (8) est induit par la première bobine électromagnétique (9) encerclant la cathode (1), et la quatrième bobine électromagnétique (10) encerclant le guide à plasma qui est la partie non rectiligne du système optique à plasma.

8. Méthode selon la revendication 6 ou la revendication 7, **caractérisée en ce que** durant le transport de flux de plasma à l'intérieur de l'anode (2), le champ magnétique supplémentaire est établi à l'aide de la bobine électromagnétique supplémentaire (16) l'encerclant, à condition que ce champ magnétique soit codirigé avec le champ magnétique constant (8), tandis que l'intensité du champ magnétique supplémentaire est amenée à varier de sorte que, pour une différence fixe de potentiel entre la cathode (1) et l'anode (2), sa valeur soit proportionnelle au courant d'arc circulant dans l'anode (2), ou pour un courant d'arc fixe circulant dans l'anode (2), sa valeur soit inversement proportionnelle à la chute de potentiel anodique.

9. Méthode selon les revendications 8 et 6, **caractérisée en ce que** dans la source de plasma, où à l'intérieur de l'anode (2) il y a le segment de tube électroconducteur (11), connecté électriquement à celle-ci et situé sur son axe, avec un bout fermé faisant face à la cathode (1) pour la réflexion de macroparticules, le flux de plasma entre la surface externe de ce segment de tube (11) et la surface interne de l'anode (2) est transporté par exposition du flux de plasma à un champ magnétique supplémentaire (13), induit par la bobine à déviation électromagnétique (12) placée coaxialement à l'intérieur du segment de tube (11), à condition que ce champ magnétique (13) soit dirigé à l'opposé du champ magnétique constant (8) sur l'axe du système optique à plasma, tandis que l'intensité de champ du champ magnétique (13) induit par cette bobine (12) est augmentée ou diminuée en rapport direct avec le courant d'arc croissant ou décroissant circulant dans le segment de tube (11).

10. Méthode selon la revendication 8, **caractérisée en ce que** le flux de plasma issu de l'anode (2) est transporté dans le guide à plasma, à l'intérieur duquel le flux de plasma est exposé à un champ magnétique supplémentaire, codirigé avec le champ magnétique constant (8) et engendré avec la troisième bobine électromagnétique (18) encerclant le guide à plasma, et l'intensité du champ magnétique supplémentaire est augmentée ou diminuée en rapport direct avec le courant croissant ou décroissant circulant dans le guide à plasma.

11. Méthode selon la revendication 9, **caractérisée en ce que** le flux de plasma issu de l'anode (2) est transporté dans le guide à plasma, à l'intérieur duquel le flux de plasma est exposé à un champ magnétique supplémentaire, codirigé avec le champ magnétique constant (8) et engendré avec la quatrième bobine électromagnétique (10) encerclant le guide à plasma, et l'intensité du champ magnétique supplémentaire est augmentée ou diminuée en rapport direct avec le courant croissant ou décroissant circulant dans le guide à plasma.

12. Méthode selon la revendication 8, **caractérisée en ce que** le flux de plasma issu de l'anode (2) est transporté dans le guide à plasma, comprenant les parties entrée (4) et sortie (5) isolées électriquement l'une de l'autre et de l'anode (2), tandis que le flux de plasma est exposé à un champ magnétique supplémentaire, codirigé avec le champ magnétique constant (8) et engendré avec la troisième bobine électromagnétique (18) encerclant l'entrée de guide à plasma (4), à condition que l'intensité du champ magnétique supplémentaire soit augmentée ou réduite en rapport direct avec le courant croissant ou décroissant circulant dans la sortie de guide à plasma (5).

13. Méthode selon la revendication 9, **caractérisée en ce que** le flux de plasma issu de l'anode (2) est transporté dans le guide à plasma, comprenant les parties entrée (4) et sortie (5) isolées électriquement l'une de l'autre et de l'anode (2), tandis que le flux de plasma est exposé à un champ magnétique supplémentaire, codirigé avec le champ magnétique de transport constant (8) et engendré avec la troisième bobine électromagnétique (18) encerclant l'entrée de guide à plasma (4), à condition que l'intensité du champ magnétique supplémentaire soit augmentée ou réduite en rapport direct avec le courant croissant ou décroissant circulant dans la sortie de guide à plasma (5).
